# EUROPEAN PATENT SPECIFICATION

(11) **EP 3 580 282 B1**
(45) Date of publication and mention of the grant of the patent: **08.12.2021**
(21) Application number: 17729093.9
(22) Date of filing: 07.06.2017
(51) Int. Cl.: C09D 11/02, C09D 11/037, C09D 11/106, C09D 11/107, G03G 9/00, C09D 11/52

(54) **ELECTROSTATIC INK(S)**
ELEKTROSTATISCHE TINTE(N)
ENCRE(S) ÉLECTROSTATIQUE(S)

(43) Date of publication of application: 18.12.2019
(73) Proprietor: HP Indigo B.V., 1187 XR Amstelveen (NL)
(72) Inventor: GRINWALD, Yaron, 76101 Nes Ziona (IL); GUSLITZER, Regina, 76101 Nes Ziona (IL); KATZ, Gregory, 76101 Nes Ziona (IL); HAGEGE, Ariel, 76101 Nes Ziona (IL)
(74) Representative: Haseltine Lake Kempner LLP
(86) International application number: PCT/EP2017/063792
(87) International publication number: WO 2018/224137

(56) References cited:
- WO-A1-2015/058785
- WO-A1-2015/198881
- JP-A- 2013 185 213
- US-A1- 2014 161 976
- US-A1- 2016 370 726

## Description

### BACKGROUND

Electrostatic printing processes, sometimes termed electrophotographic printing processes, can involve creating an image on a photoconductive surface, applying an ink having charged particles to the photoconductive surface, such that they selectively bind to the image, and then transferring the charged particles in the form of the image to a print substrate.

The photoconductive surface is on a cylinder and is often termed a photo imaging plate (PIP). The photoconductive surface is selectively charged with a latent electrostatic image having image and background areas with different potentials. For example, an electrostatic ink composition including charged toner particles in a carrier liquid can be brought into contact with the selectively charged photoconductive surface. The charged toner particles adhere to the image areas of the latent image while the background areas remain clean. The image is then transferred to a print substrate (e.g., paper) directly or, more commonly, by being first transferred to an intermediate transfer member, which can be a soft swelling blanket, which is often heated to fuse the solid image and evaporate the liquid carrier, and then to the print substrate.

### BRIEF DESCRIPTION OF THE FIGURES

FIG. 1 shows a confocal microscope photo of an example of an electrostatic ink described herein when printed on paper after 2 layers of the electrostatic ink were deposited on the paper.
FIG. 2 shows a confocal microscope photo of an example of an electrostatic ink described herein when printed on paper after 15 layers of the electrostatic ink were deposited on the paper.

### DETAILED DESCRIPTION

It is noted that, as used in this specification and the appended claims, the singular forms "a," "an," and "the" include plural referents unless the context clearly dictates otherwise.

As used herein, "liquid carrier," "carrier liquid," "carrier," or "carrier vehicle" refers to the fluid in which the polymers, conductive pigment such as the metal or metal alloy pigment mentioned herein, charge directors and/or other additives can be dispersed to form a liquid electrostatic ink or electrophotographic ink. Liquid carriers can include a mixture of a variety of different agents, such as surfactants, co-solvents, viscosity modifiers, and/or other possible ingredients.

As used herein, "electrostatic ink composition" generally refers to an ink composition, which may be in liquid form, that can be used in an electrostatic printing process, sometimes termed an electrophotographic printing process. The electrostatic ink composition may comprise chargeable particles of the thermoplastic resin and the metal or metal alloy pigment, which may be as described herein, dispersed in a liquid carrier, which may be as described herein.

As used herein, "co-polymer" refers to a polymer that is polymerized from at least two monomers.

A certain monomer may be described herein as constituting a certain weight percentage of a polymer. This indicates that the repeating units formed from the said monomer in the polymer constitute said weight percentage of the polymer.

If a standard test is mentioned herein, unless otherwise stated, the version of the test to be referred to is the most recent at the time of filing this patent application.

As used herein, "electrostatic(ally) printing" or "electrophotographic(ally) printing" generally refers to the process that generates an image that is transferred from a photo imaging substrate or plate either directly or indirectly via an intermediate transfer member to a print substrate, *e.g.*, a paper substrate. As such, the image is not substantially absorbed into the photo imaging substrate or plate on which it is applied. Additionally, "electrophotographic printers" or "electrostatic printers" generally refer to those printers capable of performing electrophotographic printing or electrostatic printing, as described above. "Liquid electrophotographic printing" is a specific type of electrophotographic printing where a liquid ink is employed in the electrophotographic process rather than a powder toner. An electrostatic printing process may involve subjecting the electrostatic ink composition to an electric field, *e.g.*, an electric field having a field strength of 1000 V/cm or more, in some examples 1000 V/mm or more.

As used herein, the term "about" is used to offer flexibility to a numerical range endpoint by offering that a given value may be a little above or a little below the endpoint. The degree of flexibility of this term can be dictated by the particular variable and the associated description herein.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list based on their presentation in a common group without indications to the contrary.

Concentrations, amounts, and other numerical data may be expressed or presented herein in a range format. It is to be understood that such a range format is used merely for convenience and brevity and thus should be interpreted flexibly to include not just the numerical values explicitly recited as the limits of the range, but also to include all the individual numerical values or sub-ranges encompassed within that range as if each numerical value and sub-range is explicitly recited. As an illustration, a numerical range of "about 1 wt% to about 5 wt%" should be interpreted to include not just the explicitly recited values of about 1 wt% to about 5 wt%, but also include individual values and subranges within the indicated range. Thus, included in this numerical range are individual values such as 2, 3.5, and 4 and sub-ranges such as from 1-3, from 2-4, and from 3-5, *etc.* The same applies to ranges reciting a single numerical value. Furthermore, such an interpretation should apply regardless of the breadth of the range or the characteristics being described.

Unless otherwise stated, any feature described herein can be combined with any example or any other feature described herein.

In some examples, printing electrically conductive traces on substrates can be achieved by using certain printing techniques, such as ink jet printing or screen printing. However, such printing techniques generally involve a post printing treatment to increase the conductivity of the printed traces. In some instances, the post-treatment to achieve high conductivity involves heating the printed substrate to high temperatures (this is known as sintering). Sintering of some metals ― *e.g*., silver can involve heating a printed substrate to a high temperature of about 300-700°C for an extended period. This allows conductive traces to be printed on certain limited materials, such as glass, silicon, and ceramics. However, such sintering is unsuitable for most flexible substrates such paper and plastic, because these substrates would deteriorate at high temperatures.

Described hereinbelow are electrostatic inks that can be electroconductive. The electrically conductive electrostatic ink composition comprises a liquid carrier; and particles dispersed in the liquid carrier, wherein the particles comprise: thermoplastic resin, and electrically conductive metal particles comprising: a core comprising a first metal, and a shell comprising a second metal, wherein the shell encloses the core at least partially, and wherein the first metal and the second metal are not the same, wherein the metal particles comprise from 10 wt% to 40 wt% of the second material based on the total weight of the metal particles.

In some examples, the first metal and the second metal can be selected from the group consisting of copper, silver, gold, platinum, titanium, chromium, manganese, iron, nickel rhodium, iridium, and combinations thereof. The first metal and the second metal are not the same.

In some examples, the first metal can be copper and the second metal can be silver.

As manufacturing technologies for electronic devices (*e.g*., traces) continue to evolve it is becoming increasingly helpful to study different techniques for manufacturing these devices using low cost materials and methods. Noble metals can generally and most commonly be used as raw materials in manufacturing electronic devices. However, these noble metals (*e.g*., Ag or Pt) can be expensive and can raise manufacturing costs. There is, therefore, a need to replace these noble metals with materials of low cost. Less expensive metals (*e.g*., copper or nickel) can have similar physical and chemical properties compared with noble metals. However, the antioxidation property of, for example, copper is weak. Therefore, to compensate for this, copper can be coated with a noble metal.

In some examples described hereinbelow, silver coated copper particles can be used in electrostatic inks to print traces. Such particles have high bulk electrical conductivity and are stable because of the noble metal (*e.g.,* silver) shell protecting the metal core (*e.g.,* copper) particle.

Examples described hereinbelow show that when (i) the metal particles (*e.g.*, core-shell metal particles) constitute at least about 75 wt% of the solids of the electrostatic ink composition and/or (ii) the metal particles comprise from about 10 wt% to about 40 wt% of a noble metal based on the total weight of the metal particles, the printed ink can be electrically conductive without the high costs associated with using metal particles comprising 100 wt% noble metals.

Examples described hereinbelow allow obtaining electrically conductive ink while reducing the price of the electrostatic ink because pure noble metal (*e.g.*, silver or platinum) particles are more expensive than cheaper conductive metals coated with noble metals (*e.g*., silver coated copper) particles. Additionally, pure copper metal particles are generally not used in obtaining electrically conductive properties because pure copper can easily oxidize in air and oxidized copper can have reduced electrical conductivity compared with pure copper.

Examples described hereinbelow also show that conductive traces can be printed with no additional necessary treatment - e.g., sintering at temperatures as high as about 700°C. As a result of a printing process that does not involve temperatures higher than about 170°C, flexible substrates such as plastic or paper can be used.

Examples described hereinbelow also show that no post-treatment - e.g., curing or sintering are necessary to achieve electrical conductivity. The printed electrically conductive trace can rely on good particle to particle physical contact with very low contact resistance in the defined percolated printed traces.

### Electrostatic Ink(s)

In some examples, an electrically conductive electrostatic ink composition is described. The electrically conductive electrostatic ink composition can comprise: a liquid carrier; and particles dispersed in the liquid carrier, wherein the particles comprise: thermoplastic resin, and electrically conductive metal particles comprising: a core comprising a first metal, and a shell comprising a second metal, wherein the shell encloses the core at least partially, and wherein the first metal and the second metal are not the same, wherein the metal particles comprise from 10 wt% to 40 wt% of the second material based on the total weight of the metal particles.

In some examples, the first metal and the second metal can be selected from the group consisting of copper, silver, gold, platinum, titanium, chromium, manganese, iron, nickel rhodium, iridium, and combinations thereof. The first metal and the second metal are not the same.

In some examples, the first metal can be copper and the second metal can be silver.

In some examples, the thermoplastic resin can comprise a polymer selected from a co-polymer of (i) ethylene or propylene and (ii) an ethylenically unsaturated acid of either acrylic acid or methacrylic acid; and ionomers thereof.

In some examples, the electrically conductive electrostatic ink composition can further comprise a charge director.

In some examples, the liquid carrier can constitute at least 30 wt% of the electrically conductive electrostatic ink composition, or the liquid carrier can constitute at least about 40 wt% of the electrically conductive electrostatic ink composition, or the liquid carrier can constitute at least about 50 wt% of the electrically conductive electrostatic ink composition, or the liquid carrier can constitute at least about 60 wt% of the electrically conductive electrostatic ink composition, or the liquid carrier can constitute at least about 70 wt% of the electrically conductive electrostatic ink composition, or the liquid carrier can constitute at least about 80 wt% of the electrically conductive electrostatic ink composition.

### Metal particles

In some examples, the metal particles can constitute at least about 75 wt% of the solids of the electrostatic ink composition, or the metal particles can constitute at least about 80 wt% of the solids of the electrostatic ink composition, or the metal particles can constitute at least about 82 wt% of the solids of the electrostatic ink composition, or the metal particles can constitute at least about 85 wt% of the solids of the electrostatic ink composition, or the metal particles can constitute at least about 90 wt% of the solids of the electrostatic ink composition, or the metal particles can constitute at least about 92 wt% of the solids of the electrostatic ink composition, or the metal particles can constitute at least about 95 wt% of the solids of the electrostatic ink composition, or the metal particles can constitute at least about 97 wt% of the solids of the electrostatic ink composition.

In some examples, the particles dispersed in the liquid carrier can comprise: from about 5 wt% to about 25 wt% of the thermoplastic resin based on the total weight of the particles dispersed in the liquid carrier; and from about 75 wt% to about 95 wt% of the metal particles based on the total weight of the particles dispersed in the liquid carrier. In some examples, the particles dispersed in the liquid carrier can comprise: from about 10 wt% to about 20 wt% of the thermoplastic resin based on the total weight of the particles dispersed in the liquid carrier; and from about 80 wt% to about 90 wt% of the metal particles based on the total weight of the particles dispersed in the liquid carrier. In some examples, the particles dispersed in the liquid carrier can comprise: from about 12 wt% to about 18 wt% of the thermoplastic resin based on the total weight of the particles dispersed in the liquid carrier; and from about 82 wt% to about 88 wt% of the metal particles based on the total weight of the particles dispersed in the liquid carrier.

In some examples, the shell can substantially completely enclose the core. In some examples, the shell can completely enclose the core. In some examples, the shell can enclose at least about 90% of the core surface area, or the shell can enclose at about least 91% of the core surface area, or the shell can enclose at least about 92% of the core surface area, or the shell can enclose at least about 93% of the core surface area, or the shell can enclose at least about 94% of the core surface area, or the shell can enclose at least about 95% of the core surface area, or the shell can enclose at least about 96% of the core surface area, or the shell can enclose at least about 97% of the core surface area, or the shell can enclose at least about 98% of the core surface area, or the shell can enclose at least about 99% of the core surface area, or the shell can enclose about 100% of the core surface area.

In some examples, the shell thickness can be from about 0.01 µm to about 10 µm, or the shell thickness can be from about 0.1 µm to about 3 µm, or the shell thickness can be from about 0.2 µm to about 2 µm, the shell thickness can be from about 0.3 µm to about 1 µm, or the shell thickness can be from about 0.4 µm to about 0.9 µm, or the shell thickness can be from about 0.5 µm to about 0.8 µm, or the shell thickness can be from about 0.6 µm to about 0.7 µm, or the shell thickness can be less than about 2 µm, or the shell thickness can be less than about 1 µm, or the shell thickness can be less than about 0.1 µm, or the shell thickness can be from about 0.01 µm to about 0.1 µm.

In some examples, the metal particles can have a diameter of from about 1 µm to about 20 µm, or the metal particles can have a diameter of from about 1 µm to about 10 µm, the metal particles can have a diameter of from about 1 µm to about 9 µm, the metal particles can have a diameter of from about 1 µm to about 8 µm, or the metal particles can have a diameter of from about 1 µm to about 7 µm, or the metal particles can have a diameter of from about 1 µm to about 6 µm, or the metal particles can have a diameter of from about 1 µm to about 5 µm, or the metal particles can have a diameter of less than about 20 µm, or the metal particles can have a diameter of less than about 15 µm, or the metal particles can have a diameter of less than about 12 µm, or the metal particles can have a diameter of less than about 10 µm, or the metal particles can have a diameter of less than about 9 µm, or the metal particles can have a diameter of less than about 8 µm, or the metal particles can have a diameter of less than about 7 µm, or the metal particles can have a diameter of less than about 6 µm, or the metal particles can have a diameter of less than about 5 µm.

The metal particles comprise from 10 wt% to 40 wt% of the second (*e.g.,* silver or platinum) metal based on the total weight of the metal particles, or the metal particles can comprise from about 11 wt% to about 35 wt% of the second metal based on the total weight of the metal particles, or the metal particles can comprise from about 12 wt% to about 30 wt% of the second metal based on the total weight of the metal particles, or the metal particles can comprise from about 13 wt% to about 25 wt% of the second metal based on the total weight of the metal particles, or the metal particles can comprise from about 14 wt% to about 20 wt% of the second metal based on the total weight of the metal particles, or the metal particles can comprise from about 14 wt% to about 19 wt% of the second metal based on the total weight of the metal particles, or the metal particles can comprise from about 14 wt% to about 18 wt% of the second metal based on the total weight of the metal particles, or the metal particles can comprise from about 14 wt% to about 17 wt% of the second metal based on the total weight of the metal particles, or the metal particles can comprise from about 14 wt% to about 16 wt% of the second metal based on the total weight of the metal particles, or the metal particles can comprise less than about 50 wt% of the second metal based on the total weight of the metal particles, or the metal particles can comprise less than about 45 wt% of the second metal based on the total weight of the metal particles, or the metal particles can comprise less than about 40 wt% of the second metal based on the total weight of the metal particles, or the metal particles can comprise less than about 35 wt% of the second metal based on the total weight of the metal particles, the metal particles can comprise less than about 30 wt% of the second metal based on the total weight of the metal particles, the metal particles can comprise less than about 25 wt% of the second metal based on the total weight of the metal particles, or the metal particles can comprise less than about 20 wt% of the second metal based on the total weight of the metal particles, the metal particles can comprise less than about 15 wt% of the second metal based on the total weight of the metal particles, or the metal particles can comprise at least about 10 wt% of the second metal based on the total weight of the metal particles, or the metal particles can comprise at least about 12 wt% of the second metal based on the total weight of the metal particles, or the metal particles can comprise at least about 14 wt% of the second metal based on the total weight of the metal particles, or the metal particles can comprise at least about 15 wt% of the second metal based on the total weight of the metal particles, or the metal particles can comprise at least about 20 wt% of the second metal based on the total weight of the metal particles.

In some examples, the metal particles can be commercially available ― *e.g*., AZS-315 from Ames Goldsmith Corp.

In some examples, the metal particles can be manufactured using many different techniques ― *e.g.*, wet chemical method, electrochemical synthesis, and/or atomic layer deposition.

In some examples, the wet chemical method can include different techniques ― *e.g.*, microwave heating (in this method a mixture of metal precursors, surfactants, and reductants are heated in a microwave synthesis system); one-pot simultaneous reduction method (in this method NAFION^{™} is mixed with deoxidized Milli-Q water for about 30 minutes, then metal precursors are added under an atmosphere of nitrogen in the dark, and then reductants are added and stirred for about 1 hour at about 0°C); ultraviolet irradiation method (in this methods metal precursors are mixed with polyethylene glycol and acetone and then the mixture is exposed to ultraviolet irradiation); and/or successive reduction method (in this method metal precursors are reduced to the target particle size and then these particles are used as seeds to reduce other metal precursors to form core-shell structures).

In some examples, the electrochemical synthesis method can include different techniques - *e.g.,* electrochemical self-organization method (in this method the core metal particle is treated and then the shell metal is electrodeposited on the core) and galvanic displacement method (in this method some core metal atoms are displaced with another metal monolayer).

In some examples, the atomic layer deposition method can include using a viscous flow reactor to atomically deposit the shell metal onto the core.

### Liquid Carrier

The electrically conductive electrostatic ink composition comprises a liquid carrier. Generally, the liquid carrier can act as a dispersing medium for the other components in the electrostatic ink composition. For example, the liquid carrier can comprise or be a hydrocarbon, silicone oil, vegetable oil, or combination thereof. The liquid carrier can include, but is not limited to, an insulating, non-polar, non-aqueous liquid that can be used as a medium for toner particles, *e.g.,* the particles containing the resin and the metal or metal alloy pigment(s).

The liquid carrier can include compounds that have a resistivity in excess of about 10⁹ ohm-cm. The liquid carrier may have a dielectric constant below about 5, in some examples below about 3. The liquid carrier can include, but is not limited to, hydrocarbons. The hydrocarbon can include, but is not limited to, an aliphatic hydrocarbon, an isomerized aliphatic hydrocarbon, branched chain aliphatic hydrocarbons, aromatic hydrocarbons, and combinations thereof.

Examples of the liquid carriers include, but are not limited to, aliphatic hydrocarbons, isoparaffinic compounds, paraffinic compounds, dearomatized hydrocarbon compounds, and the like. In particular, the liquid carriers can include, but are not limited to, Isopar-G^{™}, Isopar-H^{™}, Isopar-L^{™}, Isopar-M^{™}, Isopar-K^{™}, Isopar-V^{™}, Norpar 12^{™}, Norpar 13^{™}, Norpar 15^{™}, Exxol D40^{™}, Exxol D80^{™}, Exxol D100^{™}, Exxol D130^{™}, and Exxol D140^{™} (each sold by EXXON CORPORATION); Teclen N-16^{™}, Teclen N-20^{™}, Teclen N-22^{™}, Nisseki Naphthesol L^{™}, Nisseki Naphthesol M^{™}, Nisseki Naphthesol H^{™}, #0 Solvent L^{™}, #0 Solvent M^{™}, #0 Solvent H^{™}, Nisseki Isosol 300^{™}, Nisseki Isosol 400^{™}, AF-4^{™}, AF-5^{™}, AF-6^{™} and AF-7^{™} (each sold by NIPPON OIL CORPORATION); IP Solvent 1620^{™} and IP Solvent 2028^{™} (each sold by IDEMITSU PETROCHEMICAL CO., LTD.); Amsco OMS^{™} and Amsco 460^{™} (each sold by AMERICAN MINERAL SPIRITS CORP.); and Electron, Positron, New II, Purogen HF (100% synthetic terpenes) (sold by ECOLINK^{™}).

In some examples, the liquid carrier can constitute about 20% to about 99.5% by weight of the electrostatic ink composition, in some examples about 50% to about 99.5% by weight of the electrostatic ink composition. The liquid carrier may constitute about 40% to about 90% by weight of the electrostatic ink composition. The liquid carrier may constitute about 60% to about 80% by weight of the electrostatic ink composition. The liquid carrier may constitute about 90% to about 99.5% by weight of the electrostatic ink composition, in some examples about 95% to about 99% by weight of the electrostatic ink composition.

The ink, when printed on the print substrate, may be substantially free from liquid carrier. In an electrostatic printing process and/or afterwards, the liquid carrier may be removed, *e.g.,* by an electrophoresis processes during printing and/or evaporation, such that substantially just solids are transferred to the print substrate. Substantially free from liquid carrier may indicate that the ink printed on the print substrate contains less than about 5 wt% liquid carrier, or less than about 2 wt% liquid carrier, or less than about 1 wt% liquid carrier, or less than about 0.5 wt% liquid carrier, or less than about 0.1 wt% liquid carrier. In some examples, the ink printed on the print substrate is free from liquid carrier.

In some examples, the total solids wt% in the electrostatic ink composition can be less than about 10 wt% based on the total weight of the electrostatic ink composition, or less than about 9 wt% based on the total weight of the electrostatic ink composition, or less than about 8 wt% based on the total weight of the electrostatic ink composition, or less than about 7 wt% based on the total weight of the electrostatic ink composition, or less than about 6 wt% based on the total weight of the electrostatic ink composition, or less than about 5 wt% based on the total weight of the electrostatic ink composition, or from about 1 wt% to about 20 wt% based on the total weight of the electrostatic ink composition, or from about 2 wt% to about 15 wt% based on the total weight of the electrostatic ink composition, or from about 3 wt% to about 10 wt% based on the total weight of the electrostatic ink composition, or from about 4 wt% to about 8 wt% based on the total weight of the electrostatic ink composition.

### Thermoplastic Resin

In some examples, the electrically conductive electrostatic ink composition comprises a resin, which may be a thermoplastic resin. In some examples, a thermoplastic polymer is sometimes referred to as a thermoplastic resin. The resin may coat the metal or metal alloy pigment, such that the particles comprise a core of metal or metal alloy pigment, and have an outer layer of resin thereon. The outer layer of resin may coat the pigment partially or completely.

In some examples, the polymer of the resin may be selected from ethylene or propylene acrylic acid co-polymers; ethylene or propylene methacrylic acid co-polymers; ethylene vinyl acetate co-polymers; co-polymers of ethylene or propylene (*e.g*., about 80 wt% to about 99.9 wt%), and alkyl (*e.g.*, C1 to C5) ester of methacrylic or acrylic acid (*e.g*., about 0.1 wt% to about 20 wt%); co-polymers of ethylene (*e.g*., about 80 wt% to about 99.9 wt%), acrylic or methacrylic acid (*e.g*., about 0.1 wt% to about 20.0 wt%) and alkyl *(e.g.,* C1 to C5) ester of methacrylic or acrylic acid (*e.g.*, about 0.1 wt% to about 20 wt%); co-polymers of ethylene or propylene (*e.g*., about 70 wt% to about 99.9 wt%) and maleic anhydride (*e.g*., about 0.1 wt% to about 30 wt%); polyethylene; polystyrene; isotactic polypropylene (crystalline); co-polymers of ethylene ethylene ethyl acrylate; polyesters; polyvinyl toluene; polyamides; styrene/butadiene co-polymers; epoxy resins; acrylic resins (*e.g*., co-polymer of acrylic or methacrylic acid and at least one alkyl ester of acrylic or methacrylic acid wherein alkyl may have from 1 to about 20 carbon atoms, such as methyl methacrylate (*e.g*., about 50% to about 90%)/methacrylic acid (*e.g*., about 0 wt% to about 20 wt%)/ethylhexylacrylate (*e.g*., about 10 wt% to about 50 wt%)); ethylene-acrylate terpolymers: ethylene-acrylic esters-maleic anhydride (MAH) or glycidyl methacrylate (GMA) terpolymers; ethylene-acrylic acid ionomers and combinations thereof.

In some examples, the resin may comprise a polymer having acidic side groups. Examples of the polymer having acidic side groups will now be described. The polymer having acidic side groups may have an acidity of about 50 mg KOH/g or more, in some examples an acidity of about 60 mg KOH/g or more, in some examples an acidity of about 70 mg KOH/g or more, in some examples an acidity of about 80 mg KOH/g or more, in some examples an acidity of about 90 mg KOH/g or more, in some examples an acidity of about 100 mg KOH/g or more, in some examples an acidity of about 105 mg KOH/g or more, in some examples about 110 mg KOH/g or more, in some examples about 115 mg KOH/g or more. The polymer having acidic side groups may have an acidity of about 200 mg KOH/g or less, in some examples about 190 mg or less, in some examples about 180 mg or less, in some examples about 130 mg KOH/g or less, in some examples about 120 mg KOH/g or less. Acidity of a polymer, as measured in mg KOH/g can be measured using standard procedures known in the art, for example using the procedure described in ASTM D1386.

The resin may comprise a polymer, in some examples a polymer having acidic side groups, that has a melt flow rate of less than about 70 g/10 minutes, in some examples about 60 g/10 minutes or less, in some examples about 50 g/10 minutes or less, in some examples about 40 g/10 minutes or less, in some examples about 30 g/10 minutes or less, in some examples about 20 g/10 minutes or less, in some examples about 10 g/10 minutes or less. In some examples, all polymers having acidic side groups and/or ester groups in the particles each individually have a melt flow rate of less than about 90 g/10 minutes, in some examples about 80 g/10 minutes or less, in some examples about 70 g/10 minutes or less, in some examples about 60 g/10 minutes or less.

The polymer having acidic side groups can have a melt flow rate of about 10 g/10 minutes to about 120 g/10 minutes, in some examples about 10 g/10 minutes to about 70 g/10 minutes, in some examples about 10 g/10 minutes to 40 g/10 minutes, in some examples about 20 g/10 minutes to about 30 g/10 minutes. The polymer having acidic side groups can have a melt flow rate of, in some examples, about 50 g/10 minutes to about 120 g/10 minutes, in some examples about 60 g/10 minutes to about 100 g/10 minutes. The melt flow rate can be measured using standard procedures known in the art, for example as described in ASTM D1238.

The acidic side groups may be in free acid form or may be in the form of an anion and associated with counterion(s), such as metal counterions, *e.g.,* a metal selected from the alkali metals, such as lithium, sodium and potassium, alkali earth metals, such as magnesium or calcium, and transition metals, such as zinc. The polymer having acidic sides groups can be selected from resins such as co-polymers of ethylene and an ethylenically unsaturated acid of either acrylic acid or methacrylic acid; and ionomers thereof, such as methacrylic acid and ethylene-acrylic or methacrylic acid co-polymers which are at least partially neutralized with metal ions (e.g., Zn, Na, Li) such as SURLYN^{®} ionomers. The polymer comprising acidic side groups can be a co-polymer of ethylene and an ethylenically unsaturated acid of either acrylic or methacrylic acid, where the ethylenically unsaturated acid of either acrylic or methacrylic acid constitute from 5 wt% to about 25 wt% of the co-polymer, in some examples from about 10 wt% to about 20 wt% of the co-polymer.

The resin may comprise two different polymers having acidic side groups. The two polymers having acidic side groups may have different acidities, which may fall within the ranges mentioned above. The resin may comprise a first polymer having acidic side groups that has an acidity of from about 10 mg KOH/g to about 110 mg KOH/g, in some examples about 20 mg KOH/g to about 110 mg KOH/g, in some examples about 30 mg KOH/g to about 110 mg KOH/g, in some examples about 50 mg KOH/g to about 110 mg KOH/g, and a second polymer having acidic side groups that has an acidity of about 110 mg KOH/g to about 130 mg KOH/g.

The resin may comprise two different polymers having acidic side groups: a first polymer having acidic side groups that has a melt flow rate of about 10 g/10 minutes to about 50 g/10 minutes and an acidity of from about 10 mg KOH/g to about 110 mg KOH/g, in some examples about 20 mg KOH/g to about 110 mg KOH/g, in some examples about 30 mg KOH/g to about 110 mg KOH/g, in some examples about 50 mg KOH/g to about 110 mg KOH/g, and a second polymer having acidic side groups that has a melt flow rate of about 50 g/10 minutes to about 120 g/10 minutes and an acidity of about 110 mg KOH/g to about 130 mg KOH/g. The first and second polymers may be absent of ester groups.

The ratio of the first polymer having acidic side groups to the second polymer having acidic side groups can be from about 10:1 to about 2:1. The ratio can be from about 6:1 to about 3:1, in some examples about 4:1.

The resin may comprise a polymer having a melt viscosity of about 15000 poise or less, in some examples a melt viscosity of about 10000 poise or less, in some examples about 1000 poise or less, in some examples about 100 poise or less, in some examples about 50 poise or less, in some examples about 10 poise or less; said polymer may be a polymer having acidic side groups as described herein. The resin may comprise a first polymer having a melt viscosity of about 15000 poise or more, in some examples about 20000 poise or more, in some examples about 50000 poise or more, in some examples about 70000 poise or more; and in some examples, the resin may comprise a second polymer having a melt viscosity less than the first polymer, in some examples a melt viscosity of about 15000 poise or less, in some examples a melt viscosity of about 10000 poise or less, in some examples about 1000 poise or less, in some examples about 100 poise or less, in some examples about 50 poise or less, in some examples about 10 poise or less. The resin may comprise a first polymer having a melt viscosity of more than about 60000 poise, in some examples from about 60000 poise to about 100000 poise, in some examples from about 65000 poise to about 85000 poise; a second polymer having a melt viscosity of from about 15000 poise to about 40000 poise, in some examples from about 20000 poise to about 30000 poise, and a third polymer having a melt viscosity of about 15000 poise or less, in some examples a melt viscosity of about 10000 poise or less, in some examples about 1000 poise or less, in some examples about 100 poise or less, in some examples about 50 poise or less, in some examples about 10 poise or less; an example of the first polymer is NUCREL^{®} 960 (from DuPont), and example of the second polymer is NUCREL^{®} 699 (from DuPont), and an example of the third polymer is A-C^{®} 5120 or A-C^{®} 5180 (from Honeywell). The first, second and third polymers may be polymers having acidic side groups as described herein. The melt viscosity can be measured using a rheometer, *e.g.,* a commercially available AR-2000 Rheometer from Thermal Analysis Instruments, using the geometry of: 25 mm steel plate-standard steel parallel plate, and finding the plate over plate rheometry isotherm at about 120 °C, about 0.01 hertz shear rate.

If the thermoplastic resin in the electrically conductive electrostatic ink composition comprises a single type of polymer, the polymer (excluding any other components of the electrostatic ink composition) may have a melt viscosity of about 6000 poise or more, in some examples a melt viscosity of about 8000 poise or more, in some examples a melt viscosity of about 10000 poise or more, in some examples a melt viscosity of about 12000 poise or more. If the resin comprises a plurality of polymers all the polymers of the resin may together form a mixture (excluding any other components of the electrostatic ink composition) that has a melt viscosity of about 6000 poise or more, in some examples a melt viscosity of about 8000 poise or more, in some examples a melt viscosity of about 10000 poise or more, in some examples a melt viscosity of about 12000 poise or more. Melt viscosity can be measured using standard techniques. The melt viscosity can be measured using a rheometer, *e.g.,* a commercially available AR-about 2000 Rheometer from Thermal Analysis Instruments, using the geometry of: 25 mm steel plate-standard steel parallel plate, and finding the plate over plate rheometry isotherm at about 120 °C, about 0.01 hertz shear rate.

The resin may comprise two different polymers having acidic side groups that are selected from co-polymers of ethylene and an ethylenically unsaturated acid of either acrylic acid or methacrylic acid; or ionomers thereof, such as methacrylic acid and ethylene-acrylic or methacrylic acid co-polymers which are at least partially neutralized with metal ions (*e.g*., Zn, Na, Li) such as SURLYN ^{®} ionomers. The resin may comprise (i) a first polymer that is a co-polymer of ethylene and an ethylenically unsaturated acid of either acrylic acid and methacrylic acid, wherein the ethylenically unsaturated acid of either acrylic or methacrylic acid constitutes from about 8 wt% to about 16 wt% of the co-polymer, in some examples about 10 wt% to about 16 wt% of the co-polymer; and (ii) a second polymer that is a co-polymer of ethylene and an ethylenically unsaturated acid of either acrylic acid and methacrylic acid, wherein the ethylenically unsaturated acid of either acrylic or methacrylic acid constitutes from about 12 wt% to about 30 wt% of the co-polymer, in some examples from about 14 wt% to about 20 wt% of the co-polymer, in some examples from about 16 wt% to about 20 wt% of the co-polymer in some examples from about 17 wt% to about 19 wt% of the co-polymer.

The resin may comprise a polymer having acidic side groups, as described above (which may be free of ester side groups), and a polymer having ester side groups. The polymer having ester side groups may be a thermoplastic polymer. The polymer having ester side groups may further comprise acidic side groups. The polymer having ester side groups may be a co-polymer of a monomer having ester side groups and a monomer having acidic side groups. The polymer may be a co-polymer of a monomer having ester side groups, a monomer having acidic side groups, and a monomer absent of any acidic and ester side groups. The monomer having ester side groups may be a monomer selected from esterified acrylic acid or esterified methacrylic acid. The monomer having acidic side groups may be a monomer selected from acrylic or methacrylic acid. The monomer absent of any acidic and ester side groups may be an alkylene monomer, including, but not limited to, ethylene or propylene. The esterified acrylic acid or esterified methacrylic acid may, respectively, be an alkyl ester of acrylic acid or an alkyl ester of methacrylic acid. The alkyl group in the alkyl ester of acrylic or methacrylic acid may be an alkyl group having 1 to 30 carbons, in some examples 1 to 20 carbons, in some examples 1 to 10 carbons; in some examples selected from methyl, ethyl, iso-propyl, n-propyl, t-butyl, isobutyl, n-butyl and pentyl.

The polymer having ester side groups may be a co-polymer of a first monomer having ester side groups, a second monomer having acidic side groups and a third monomer which is an alkylene monomer absent of any acidic and ester side groups. The polymer having ester side groups may be a co-polymer of (i) a first monomer having ester side groups selected from esterified acrylic acid or esterified methacrylic acid, in some examples an alkyl ester of acrylic or methacrylic acid, (ii) a second monomer having acidic side groups selected from acrylic or methacrylic acid and (iii) a third monomer which is an alkylene monomer selected from ethylene and propylene. The first monomer may constitute about 1% to about 50% by weight of the co-polymer, in some examples about 5% to about 40% by weight, in some examples about 5% to about 20% by weight of the co-polymer, in some examples about 5% to about 15% by weight of the co-polymer. The second monomer may constitute about 1% to about 50% by weight of the co-polymer, in some examples about 5% to about 40% by weight of the co-polymer, in some examples about 5% to about 20% by weight of the co-polymer, in some examples about 5% to about 15% by weight of the co-polymer. The first monomer can constitute about 5% to about 40% by weight of the co-polymer, the second monomer constitutes about 5% to about 40% by weight of the co-polymer, and with the third monomer constituting the remaining weight of the co-polymer. In some examples, the first monomer constitutes about 5% to about 15% by weight of the co-polymer, the second monomer constitutes about 5% to about 15% by weight of the co-polymer, with the third monomer constituting the remaining weight of the co-polymer. In some examples, the first monomer constitutes about 8% to about 12% by weight of the co-polymer, the second monomer constitutes about 8% to about 12% by weight of the co-polymer, with the third monomer constituting the remaining weight of the co-polymer. In some examples, the first monomer constitutes about 10% by weight of the co-polymer, the second monomer constitutes about 10% by weight of the co-polymer, and with the third monomer constituting the remaining weight of the co-polymer. The polymer may be selected from the BYNEL^{®} class of monomer, including BYNEL^{®} 2022 and BYNEL^{®} 2002, which are available from DuPont^{®}.

The polymer having ester side groups may constitute about 1% or more by weight of the total amount of the resin polymers, *e.g.,* thermoplastic resin polymers, in the electrostatic ink composition and/or the ink printed on the print substrate, *e.g.,* the total amount of the polymer or polymers having acidic side groups and polymer having ester side groups. The polymer having ester side groups may constitute about 5% or more by weight of the total amount of the resin polymers, *e.g.,* thermoplastic resin polymers, in some examples about 8% or more by weight of the total amount of the resin polymers, *e.g.,* thermoplastic resin polymers, in some examples about 10% or more by weight of the total amount of the resin polymers, *e.g.,* thermoplastic resin polymers, in some examples about 15% or more by weight of the total amount of the resin polymers, *e.g.,* thermoplastic resin polymers, in some examples about 20% or more by weight of the total amount of the resin polymers, *e.g.,* thermoplastic resin polymers, in some examples about 25% or more by weight of the total amount of the resin polymers, *e.g.,* thermoplastic resin polymers, in some examples about 30% or more by weight of the total amount of the resin polymers, *e.g.,* thermoplastic resin polymers, in some examples about 35% or more by weight of the total amount of the resin polymers, *e.g.,* thermoplastic resin polymers, in the electrostatic ink composition and/or the ink printed on the print substrate. The polymer having ester side groups may constitute from about 5% to about 50% by weight of the total amount of the resin polymers, *e.g.,* thermoplastic resin polymers, in the electrostatic ink composition and/or the ink printed on the print substrate, in some examples about 10% to about 40% by weight of the total amount of the resin polymers, *e.g.,* thermoplastic resin polymers, in the electrostatic ink composition and/or the ink printed on the print substrate, in some examples about 5% to about 30% by weight of the total amount of the resin polymers, *e.g.,* thermoplastic resin polymers, in the electrostatic ink composition and/or the ink printed on the print substrate, in some examples about 5% to about 15% by weight of the total amount of the resin polymers, *e.g.,* thermoplastic resin polymers, in the electrostatic ink composition and/or the ink printed on the print substrate in some examples about 15% to about 30% by weight of the total amount of the resin polymers, *e.g.,* thermoplastic resin polymers, in the electrostatic ink composition and/or the ink printed on the print substrate.

The polymer having ester side groups may have an acidity of about 50 mg KOH/g or more, in some examples an acidity of about 60 mg KOH/g or more, in some examples an acidity of about 70 mg KOH/g or more, in some examples an acidity of about 80 mg KOH/g or more. The polymer having ester side groups may have an acidity of about 100 mg KOH/g or less, in some examples about 90 mg KOH/g or less. The polymer having ester side groups may have an acidity of about 60 mg KOH/g to about 90 mg KOH/g, in some examples about 70 mg KOH/g to about 80 mg KOH/g.

The polymer having ester side groups may have a melt flow rate of about 10 g/10 minutes to about 120 g/10 minutes, in some examples about 10 g/10 minutes to about 50 g/10 minutes, in some examples about 20 g/10 minutes to about 40 g/10 minutes, in some examples about 25 g/10 minutes to about 35 g/10 minutes.

The polymer, polymers, co-polymer or co-polymers of the resin can in some examples be selected from the NUCREL^{®} family of toners (*e.g.,* NUCREL^{®} 403, NUCREL^{®} 407, NUCREL^{®} 609HS, NUCREL^{®} 908HS, NUCREL^{®} 1202HC, NUCREL^{®} 30707, NUCREL^{®} 1214, NUCREL^{®} 903, NUCREL^{®} 3990, NUCREL^{®} 910, NUCREL^{®} 925, NUCREL^{®} 699, NUCREL^{®} 599, NUCREL^{®} 960, NUCREL^{®} RX 76, NUCREL^{®} 2806, BYNEL^{®} 2002, BYNEL^{®} 2014, and BYNEL^{®} 2020 (sold by E. I. du PONT)), the ACLYN^{®} family of toners (*e.g.*, ACLYN^{®} 201 , ACLYN^{®} 246, ACLYN^{®} 285, and ACLYN^{®} 295), and the LOTADER^{®} family of toners (*e.g*., LOTADER^{®} 2210, LOTADER^{®} 3430, and LOTADER^{®} 8200 (sold by Arkema)).

The thermoplastic resin can, in some examples be present in the electrically conductive electrostatic ink composition in an amount of from about 1 to about 70 wt% based on the total weight of the electrostatic ink composition, or from about 1 to about 60 wt% based on the total weight of the electrostatic ink composition, or from about 1 to about 50 wt% based on the total weight of the electrostatic ink composition, or from about 1 to about 40 wt% based on the total weight of the electrostatic ink composition, or from about 1 to about 30 wt% based on the total weight of the electrostatic ink composition, or from about 1 to about 20 wt% based on the total weight of the electrostatic ink composition, or from about 5 to about 15 wt% based on the total weight of the electrostatic ink composition.

In some examples, the thermoplastic resin can constitute less than 1% by weight of the solids printed on the electrostatic ink composition, e.g., after heating, and/or rubbing, and/or plasma treatment.

As used herein, "resin," "polymer," "thermoplastic resin," or "thermoplastic polymer" are used interchangeably.

### Charge Director and Charge Adjuvants

In some examples, the electrically conductive electrostatic ink composition may include a charge director. The method as described here may involve adding a charge director at any stage. The charge director may be added to impart a charge of positive or negative polarity on particles containing the resin and the metal or metal alloy pigment. In some examples, the charge director may be selected from ionic compounds, such as metal salts of fatty acids, metal salts of sulfo-succinates, metal salts of oxyphosphates, metal salts of alkyl-benzenesulfonic acid, metal salts of aromatic carboxylic acids or sulfonic acids, as well as zwitterionic and nonionic compounds, such as polyoxyethylated alkylamines, lecithin, polyvinylpyrrolidone, organic acid esters of polyvalent alcohols, or combinations thereof.

In some examples, the charge director is selected from, but is not limited to, oil-soluble petroleum sulfonates (*e.g*., neutral Calcium Petronate^{™}, neutral Barium Petronate^{™}, and basic Barium Petronate^{™}), polybutylene succinimides (*e.g.*, OLOA^{™} 1200 and Amoco 575), and glyceride salts (*e.g.*, sodium salts of phosphated mono- and diglycerides with unsaturated and saturated acid substituents), sulfonic acid salts including, but not limited to, barium, sodium, calcium, and aluminum salts of sulfonic acid. The sulfonic acids may include, but are not limited to, alkyl sulfonic acids, aryl sulfonic acids, and sulfonic acids of alkyl succinates. In some examples, the charge director imparts a negative charge on the particles comprising the resin and metal or metal alloy pigment. In some examples, the charge director imparts a positive charge on the particles comprising the resin and metal or metal alloy pigment.

In some examples, the charge director comprises a sulfosuccinate moiety of the general formula [R_{1'}-O-C(O)CH₂CH(SO₃⁻)C(O)-O-R_{2'}], where each of R_{1'} and R_{2'} is an alkyl group. In some examples, the charge director comprises nanoparticles of a simple salt and a sulfosuccinate salt of the general formula MAₙ, wherein M is a metal, n is the valence of M, and A is an ion of the general formula [R_{1'}-O-C(O)CH₂CH(SO₃⁻)C(O)-O-R_{2'}], where each of R_{1'} and R_{2'} is an alkyl group. The sulfosuccinate salt of the general formula MAₙ is an example of a micelle forming salt. The charge director may be substantially free or free of an acid of the general formula HA, where A is as described above. The charge director may comprise micelles of said sulfosuccinate salt enclosing at least some of the nanoparticles. The charge director may comprise at least some nanoparticles having a size of 200 nm or less, in some examples 2 nm or more. Simple salts are salts that do not form micelles by themselves, although they may form a core for micelles with a micelle forming salt. The ions constructing the simple salts are all hydrophilic. The simple salt may comprise a cation selected from Mg, Ca, Ba, NH₄, tert-butyl ammonium, Li⁺, and Al⁺³, or from any sub-group thereof. The simple salt may comprise an anion selected from SO₄²⁻, PO³⁻, NO₃⁻, HPO₄²⁻, CO₃²⁻, acetate, trifluoroacetate (TFA), Cl-, Bf, F⁻, ClO₄⁻, and TiO₃⁴⁻, or from any sub-group thereof. The simple salt may be selected from CaCO₃, Ba₂TiO₃, Al₂(SO₄), Al(NO₃)₃, Ca₃(PO₄)₂, BaSO₄, BaHPO₄, Ba₂(PO₄)₃, CaSO₄, (NH₄)₂CO₃, (NH₄)₂SO₄, NH₄OAc, Tert- butyl ammonium bromide, NH₄NO₃, LiTFA, Al₂(SO₄)₃, LiClO₄ and LiBF₄, or any sub-group thereof. The charge director may further comprise basic barium petronate (BBP).

In the formula [R_{1'}-O-C(O)CH₂CH(SO₃⁻)C(O)-O-R_{2'}], in some examples, each of R_{1'} and R_{2'} is an aliphatic alkyl group. In some examples, each of R_{1'} and R_{2'} independently is a C₆₋₂₅ alkyl. In some examples, said aliphatic alkyl group is linear. In some examples, said aliphatic alkyl group is branched. In some examples, said aliphatic alkyl group includes a linear chain of more than 6 carbon atoms. In some examples, R_{1'} and R_{2'} are the same. In some examples, at least one of R_{1'} and R_{2'} is C₁₃H₂₇. In some examples, M is Na, K, Cs, Ca, or Ba.

The charge director may comprise (i) soya lecithin, (ii) a barium sulfonate salt, such as BBP, and (iii) an isopropyl amine sulfonate salt. BBP is a barium sulfonate salt of a 21-26 hydrocarbon alkyl, and can be obtained, for example, from Chemtura. An example isopropyl amine sulphonate salt is dodecyl benzene sulfonic acid isopropyl amine, which is available from Croda.

In some examples, the charge director constitutes about 0.001% to about 20%, in some examples about 0.01% to about 20% by weight, in some examples about 0.01% to about 10% by weight, in some examples about 0.01% to about 1% by weight of the solids of the electrically conductive electrostatic ink composition. In some examples, the charge director constitutes about 0.001% to about 0.15% by weight of the solids of the electrostatic ink composition, in some examples about 0.001% to about 0.15%, in some examples about 0.001% to about 0.02% by weight of the solids of the electrically conductive electrostatic ink composition.

The electrically conductive electrostatic ink composition may include a charge adjuvant. A charge adjuvant may promote charging of the particles when a charge director is present. The method as described here may involve adding a charge adjuvant at any stage. The charge adjuvant can include, but is not limited to, barium petronate, calcium petronate, Co salts of naphthenic acid, Ca salts of naphthenic acid, Cu salts of naphthenic acid, Mn salts of naphthenic acid, Ni salts of naphthenic acid, Zn salts of naphthenic acid, Fe salts of naphthenic acid, Ba salts of stearic acid, Co salts of stearic acid, Pb salts of stearic acid, Zn salts of stearic acid, Al salts of stearic acid, Zn salts of stearic acid, Cu salts of stearic acid, Pb salts of stearic acid, Fe salts of stearic acid, metal carboxylates (*e.g*., Al tristearate, Al octanoate, Li heptanoate, Fe stearate, Fe distearate, Ba stearate, Cr stearate, Mg octanoate, Ca stearate, Fe naphthenate, Zn naphthenate, Mn heptanoate, Zn heptanoate, Ba octanoate, Al octanoate, Co octanoate, Mn octanoate, and Zn octanoate), Co lineolates, Mn lineolates, Pb lineolates, Zn lineolates, Ca oleates, Co oleates, Zn palmirate, Ca resinates, Co resinates, Mn resinates, Pb resinates, Zn resinates, AB diblock copolymers of 2-ethylhexyl methacrylate-co- methacrylic acid calcium and ammonium salts, copolymers of an alkyl acrylamidoglycolate alkyl ether (*e.g*., methyl acrylamidoglycolate methyl ether- co-vinyl acetate), and hydroxy bis(3,5-di-tert-butyl salicylic) aluminate monohydrate. In an example, the charge adjuvant is or comprises aluminum di- or tristearate. The charge adjuvant may be present in an amount of about 0.1% to about 5% by weight, in some examples about 0.1% to about 1% by weight, in some examples about 0.3% to about 0.8% by weight of the solids of the electrostatic ink composition.

In some examples, the electrically conductive electrostatic ink composition can further comprise a salt of multivalent cation and a fatty acid anion. The salt of multivalent cation and a fatty acid anion can act as a charge adjuvant. The multivalent cation may, in some examples, be a divalent or a trivalent cation. In some examples, the multivalent cation is selected from Group 2, transition metals and Group 3 and Group 4 in the Periodic Table. In some examples, the multivalent cation comprises a metal selected from Ca, Sc, Ti, V, Cr, Mn, Fe, Co, Ni, Cu, Zn, Al and Pb. In some examples, the multivalent cation is AI3+. The fatty acid anion may be selected from a saturated or unsaturated fatty acid anion. The fatty acid anion may be selected from a C8 to C26 fatty acid anion, in some examples a C14 to C22 fatty acid anion, in some examples a C16 to C20 fatty acid anion, in some examples a C17, C18 or C19 fatty acid anion. In some examples, the fatty acid anion is selected from a caprylic acid anion, capric acid anion, lauric acid anion, myristic acid anion, palmitic acid anion, stearic acid anion, arachidic acid anion, behenic acid anion and cerotic acid anion.

The charge adjuvant, which may, for example, be or comprise a salt of multivalent cation and a fatty acid anion, may be present in an amount of about 0.1 wt% to about 5 wt% of the solids of the electrically conductive electrostatic ink composition, or in an amount of about 0.1 wt% to about 2 wt% of the solids of the electrically conductive electrostatic ink composition, or in an amount of about 0.1 wt% to about 2 wt% of the solids of the electrically conductive electrostatic ink composition, or in an amount of about 0.3 wt% to about 1.5 wt% of the solids of the electrically conductive electrostatic ink composition, or in an amount of from about 0.5 wt% to about 1.2 wt% of the solids of the electrically conductive electrostatic ink composition, or in an amount of from about 0.8 wt% to about 1 wt% of the solids of the electrically conductive electrostatic ink composition.

### Other Additives

In some examples, the electrically conductive electrostatic ink composition may comprise an additive or a plurality of additives. The additive or plurality of additives may be added at any stage of the method. The additive or plurality of additives may be selected from a wax, a surfactant, biocides, organic solvents, viscosity modifiers, materials for pH adjustment, sequestering agents, preservatives, compatibility additives, emulsifiers and the like.

The wax may be an incompatible wax. As used herein, "incompatible wax" may refer to a wax that is incompatible with the resin. Specifically, the wax phase separates from the resin phase upon the cooling of the resin fused mixture on a print substrate during and after the transfer of the ink film to the print substrate, *e.g.,* from an intermediate transfer member, which may be a heated blanket.

In some examples, a wax such as a polyethylene wax (*e.g*., ACumist^{®} B-6, available from Honeywell) can be added to the electrostatic inks described herein.

In some examples, a surfactant such as a fluorosurfactant (*e.g*., Zonyl^{®} MP 1200 available from DuPont) can be added to the electrostatic inks described herein. In some examples, Solsperse^{®} 11200, Solsperse^{®} 9000, Solsperse^{®} J560 (all available from Lubrizol Corp.), or combinations thereof were added to the electrostatic inks described herein.

The amounts of the other additives added to the electrostatic inks described herein can be from about 0 wt% to about 20 wt% based on the total weight of the electrostatic ink composition. In some examples, the other additives can be can be present in the electrostatic inks described herein in an amount of from about 1 wt% to about 10 wt% based on the total weight of the electrostatic ink composition.

### Method(s) of Using Electrostatic Ink(s)

In some examples, a method of using the electrically conductive electrostatic ink composition described hereinabove can comprise adding the electrically conductive electrostatic ink composition to an ink container.

In some examples, adding the electrically conductive electrostatic ink composition to an ink container can comprise filling the ink container with the electrically conductive electrostatic ink composition.

In some examples, the ink container can be a component of an electrostatic printer, which can print images on various media by depositing patterns of the electrically conductive electrostatic ink composition from the ink container.

### Method(s) of Making Electrostatic Ink(s)

In some examples, a method of making an electrically conductive electrostatic ink composition can comprise: mixing a liquid carrier and particles dispersed in the liquid carrier, wherein the particles comprise:
thermoplastic resin, and electrically conductive metal particles comprising: a core comprising a first metal, and a shell comprising a second metal,
wherein the shell encloses the core at least partially, and wherein the first metal and the second metal are not the same, wherein the metal particles comprise from 10 wt% to 40 wt% of the second material based on the total weight of the metal particles.

In some examples, the method of making an electrically conductive electrostatic ink may include:
i) mixing an ethylene acid copolymer with an ethylene/(meth)acrylic acid C1-10 alkyl ester copolymer, said copolymer being present in an amount as presently disclosed, in the presence of a liquid vehicle,
ii) grinding the particles obtained in i) till the achievement of a particle size from about 0.1 micron to about 10 microns, and
iii) forming electrically conductive electrostatic ink particles by mixing the particles obtained in ii) with electrically conductive metal particles. The mixing is carried out until the electrically conductive metal particles form a homogeneous mixture with the other particles of the electrostatic ink composition. It is to be understood that mixing of the electrically conductive metal particles to obtain a homogenous electrostatic ink composition can aid in achieving improved printing and print quality.

It is to be understood that at least one solvent and other additives like surfactants and charge directors can be added during i), ii), and/or iii) described above.

In some examples, the electrically conductive particles can comprise a core comprising a first metal, and a shell comprising a second metal, wherein the shell encloses the core at least partially, and wherein the first metal and the second metal are not the same. In some examples, the first metal and the second metal can be selected from the group consisting of copper, silver, gold, platinum, titanium, chromium, manganese, iron, nickel rhodium, iridium, and combinations thereof. In some examples, the first metal can be copper and the second metal can be silver.

In some examples, grinding in ii) may include adding a second amount of liquid vehicle before or during grinding.

Process conditions to perform grinding may be adjusted depending on the specific colorant. Grinding may be performed for example for a time between about 1 and about 20 hours, for example between about 1 and about 15 hours, for example between about 10 and about 15 hours. Grinding can be performed using a single temperature profile or a temperature profile with stages. For example, temperature may not be higher than about 50° C, such as not higher than about 45° C.

If a colorant is added, it may be added either in i), ii), or iii).

If a charge adjuvant, a charge director, a surface modifier, compatibility additives, charging additives, a wax, a biocide, a sequestering agent, a preservative, an emulsifier or transfer additives is/are added, these ingredients may be added in i), ii), or iii).

### Printing Process and Print Substrate

In some examples, disclosed herein is a method of electrostatic printing on a print substrate, the method comprising: forming a latent electrostatic image on a surface; contacting the surface with an electrostatic ink composition, such that at least some of the particles adhere to the surface to form a developed toner image on the surface and transferring the toner image to the print substrate.

In some examples, the electrically conductive electrostatic ink composition can comprise a liquid carrier; and particles dispersed in the liquid carrier, wherein the particles comprise: thermoplastic resin, and electrically conductive metal particles comprising: a core comprising a first metal, and a shell comprising a second metal, wherein the shell encloses the core at least partially, and wherein the first metal and the second metal are not the same.

The surface on which the (latent) electrostatic image is formed or developed may be on a rotating member, *e.g.,* in the form of a cylinder. The surface on which the (latent) electrostatic image is formed or developed may form part of a photo imaging plate (PIP). The method may involve passing the electrostatic ink composition described herein between an electrode, which may be stationary, and a rotating member, which may be a member having the surface having the (latent) electrostatic image thereon or a member in contact with the surface having the (latent) electrostatic image thereon. A voltage is applied between the electrode and the rotating member, such that particles adhere to the surface of the rotating member. The intermediate transfer member, if present, may be a rotating flexible member, which may be heated, *e.g.,* to a temperature of from 60 to 140 °C.

In some examples, the rotating member can rotate such that successive images may be transferred to the same region of the rotating member for at least 2 layers of print and up to as many as 50 layers of print. Thus, a plurality of electrostatic images may be transferred, in superimposed registration with one another, to the rotating member.

In some examples, the printing method can further comprise, after transferring the toner image to the print substrate, heating the print substrate and/or rubbing an object over the toner image on the print substrate, to decrease the electrical resistance of the toner image. Rubbing an object over the toner image may indicate contacting an object with the toner image and effecting relative lateral movement on the print substrate and the object, such that the object moves across the print image. The rubbing may involve pressing together the print substrate and the object. Rubbing may be carried out manually or in an automated manner. Rubbing may involve moving an object in contact with the ink on the paper at a different velocity relative to the paper. In some examples, the applied force can range from about 240 kgf to about 400 kgf, or from about 280 kgf to about 370 kgf, or from about 290 kgf to about 350 kgf, or from about 300 kgf to about 350 kgf. The object in contact with the ink and used for the rubbing may comprise a material selected from plastic, rubber, glass, metal, and paper, which may be soft or strong paper. In some examples, the rubbing element can be heated, which has been found to improve efficiency.

In an example of the method, the heating involves heating the print substrate to a temperature of at least about 80 °C, in some examples at least about 90 °C, in some examples at least about 100 °C, in some examples at least about 120 °C, in some examples at least about 130 °C, in some examples at least about 150 °C, in some examples at least about 180 °C, in some examples at least about 220 °C, in some examples at least about 250 °C, in some examples at least about 280 °C. The heating may be carried out for a predetermined period.

In some examples, the heating may be carried out until a sheet resistance of the ink printed on the substrate is about 50 Ω/sq or less, in some examples about 40 Ω/sq or less, in some examples about 30 Ω/sq or less, in some examples about 20 Ω/sq or less, in some examples about 15 Ω/sq or less, in some examples 10 Ω/sq or less.

In an example of the method, the heating involves heating the print substrate to a temperature of from about 80 °C to about 250 °C, for at a predetermined period of least 5 minutes, in some examples at least about 10 minutes, in some examples at least about 15 minutes, in some examples at least about 20 minutes, in some examples at least about 25 minutes, in some examples at least about 30 minutes. The predetermined period may be from about 5 to about 60 minutes, in some examples from about 15 to about 45 minutes.

In an example of the method, the heating involves heating the print substrate to a temperature of from about 80°C to about 250°C, in some examples of from about 100°C to about 200°C, in some examples of from about 100°C to about 150°C, in some examples from about 110°C to about 140°C, for at least about 15 minutes, and, in some examples and at most about 1 hour.

In an example of the method, the heating involves heating the print substrate to a maximum temperature of at least about 250 °C, in some examples for at least about 10 seconds. In an example of the method, the heating involves heating the print substrate to a maximum temperature of at least about 250 °C, in some examples from about 250 °C to about 350 °C, in some examples for at least about 10 seconds in some examples at least about 20 seconds, in some examples at least about 30 second, and, in some examples and at most about 5 minutes, in some examples at most about 3 minutes, in some examples at most about 2 minutes, in some examples about 90 seconds.

In an example of the method, the printing method can further comprise, after transferring the toner image to the print substrate, subjecting the print substrate to a plasma treatment. The substrate may be subjected to a plasma treatment for a period of at least about 1 minute, in some examples at least about 5 minutes, in some examples at least about 10 minutes, in some examples a period of from about 5 minutes to about 60 minutes, in some examples about 5 minutes to about 30 minutes, in some examples about 10 minutes to about 20 minutes, in some examples about 12 to about 18 minutes, in some examples about 15 minutes.

In an example of the method, before contacting the surface with the electrically conductive electrostatic ink composition, the composition is passed between an electrode and a developer roller, the electrically conductive electrostatic composition then being passed on the developer roller, until it contacts the surface having the latent electrostatic image thereon.

In an example of the printing method, before contacting the surface with the electrically conductive electrostatic ink composition, the composition is passed between an electrode and a developer roller, and there is a potential difference V1 between the electrode and the developer roller, the electrostatic composition then being passed on the developer roller, until it contacts the surface having the latent electrostatic image thereon. The polarity of the potential difference may be such that the particles are disposed to be moved toward the developer roller and away from the electrode. The potential difference V1 may be from about 200 to about 600 V, in some examples about 300 to about 500 V, in some examples about 350 to about 450 V, in some examples about 400 V. It has been found that having relatively high potential difference assists in producing a relatively thick layer of ink on the developer roller.

In some examples, the developer roller is at a potential, relative to ground, of at least about 500 V, in some examples at least about 600 V, in some examples at least about 700 V, in some examples from about 500 V to about 1000 V, in some examples from about 600 V to about 1000 V, in some examples from about 700 V to about 900 V, in some examples from about 750 V to about 950 V.

In some examples, the developer roller is at a potential, relative to ground of about - 500 V or less, in some examples about -600 V or less, in some examples about -700 V or less, in some examples from about -500 V to about -1000 V, in some examples from about - 600 V to about -1000 V, in some examples from about -700 V to about -900 V, in some examples from about -750 V to about -950 V.

In some examples, the surface having the latent electrostatic image thereon, has a potential difference V3 between the developer roller and the area on the surface within the image (which may be termed the image area) and a potential difference V4 between the developer roller and the area on the surface outside of the image (which may be termed the non-image area). V3 may be such that the particles comprising the resin and the metal or metal alloy pigment adhere to the surface in the image area, and V4 may be such that particles are disposed to move away from the surface and toward the developer roller. In some examples, the potential difference V3 may be a value of at least about 500 V, in some examples at least about 600 V, in some examples at least about 700 V, in some examples a value of from about 500 to about 1000 V, in some examples a value of from about 600 to about 900 V, in some examples a value of from about 650 to about 850 V, in some examples a value of from about 700 to about 800 V. In some examples, the potential difference V4 may be a value of about 200 V or less, in some examples about 150 V or less, in some examples about 100 V or less, in some examples a value of from about 80 V or less, in some examples a value of about 60 V or less. It has been found that the transfer of the image seems to more effective when the potential difference between the developer roller and the image area is high relative to the potential difference between the developer roller and the non-image areas.

The print substrate may be any suitable substrate. The substrate may be any suitable substrate capable of having an image printed thereon. The substrate may comprise a material selected from an organic or inorganic material. The material may comprise a natural polymeric material, e.g., cellulose. The material may comprise a synthetic polymeric material, *e.g.,* a polymer formed from alkylene monomers, including, but not limited to, polyethylene and polypropylene, and co-polymers such as styrene-polybutadiene. In some examples, the substrate, before printing, is or comprises plastic. In some examples, the substrate, before printing, is or comprises paper. The polypropylene may, in some examples, be biaxially orientated polypropylene.

In some examples, the material may comprise a metal, which may be in sheet form.

In some examples, the substrate can comprise a cellulosic paper. In an example, the cellulosic paper is coated with a polymeric material, *e.g.,* a polymer formed from styrene-butadiene resin. In some examples, the cellulosic paper has an inorganic material bound to its surface (before printing with ink) with a polymeric material, wherein the inorganic material may be selected from, for example, kaolinite or calcium carbonate. The substrate is, in some examples, a cellulosic print substrate such as paper. The cellulosic print substrate is, in some examples, a coated cellulosic print.

Further examples will become apparent in light of the examples provided below.

### EXAMPLES

### Example 1

1020 grams of NUCREL^{®} 699, 120 grams of A-C^{®} 5120, 12 grams of a charge director, 60 grams of LOTADERO 8200, and 1800 grams of ISOPAR-L^{™} were mixed for 1.5 hours at a temperature of 150°C in a Ross double planetary mixer at a speed control setting 3. The speed was then increased to a setting of 6 for 30 minutes. The heating was stopped and the mixer was cooled with a fan while mixing was continued. The result was a pasty material.

22.5 grams of the obtained pasty material was loaded into a S0 attritor (Union Process^{®}) with {fraction (3/16)}" chrome steel grinding media with 126.5 grams of ISOPAR-L^{™} with 51 grams of silver coated copper metal particles (AZS-315 with an Ag assay of 14.09 wt% and a D50 of 3.9 µm from Ames Goldsmith Corp.). This mixture was ground at 20°C for 5 hours to obtain an electrostatic ink composition. This was diluted with ISOPAR-L^{™} to obtain a 4 wt% solids containing electrostatic ink composition.

This electrostatic ink composition was then used for printing using an LEP press (HP-Indigo 7000).

### Example 2

The electrostatic ink composition of Example 1 was used print two samples using an LEP press (HP-Indigo 7000) on paper in 2 layers and in 15 layers each. No sintering was conducted after printing.

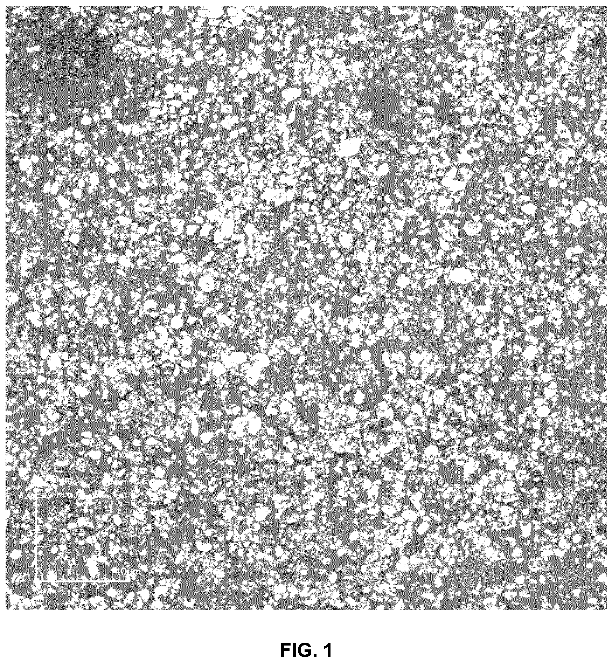

FIG. 1 shows a confocal photo of an example of the electrostatic ink of Example 1 when printed on paper after 2 layers of the electrostatic ink were deposited on the paper. The silver coated copper particles loading was 85 wt% based on the total weight of the solids in the electrostatic ink composition. As can be seen in FIG. 1, the silver coated copper particles do not make continuous physical contact with each other and as a result the printed ink (*i.e.*, trace) was not electrically conductive.

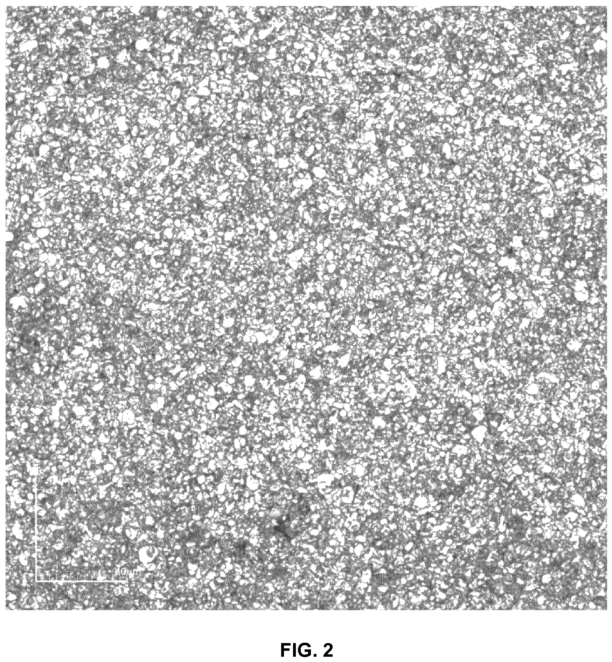

FIG. 2 shows a confocal photo of an example of the electrostatic ink of Example 1 when printed on paper after 15 layers of the electrostatic ink were deposited on the paper. The silver coated copper particles loading was 85 wt% based on the total weight of the solids in the electrostatic ink composition. As can be seen in FIG. 2, the silver coated copper particles make continuous physical contact with each other and as a result the printed ink (*i.e*., trace) was electrically conductive. The contact resistance in the trace was measured to be 5 Ω.

The above examples show that when the metal particles constitute at least about 75 wt% (e.g., 85 wt%) of the solids of the electrostatic ink composition, the printed ink is electrically conductive.

The use of silver coated copper particles, as shown in the examples above, allows obtaining electrically conductive properties in the electrostatic ink while reducing the price of the electrostatic ink because pure silver particles are more expensive that silver coated copper particles. Pure copper particles are generally not used in obtaining electrically conductive properties because pure copper can easily oxidize in air and oxidized copper can have reduced electrical conductivity compared with pure copper.

The above examples also that conductive traces can be printed with no additional necessary treatment ― *e.g.,* sintering at temperatures as high as 700°C. As a result of a printing process that does not entail temperatures higher than about 170°C, flexible substrates such as plastic or paper can be used.

The above examples also show that no post-treatment ― *e.g.,* curing or sintering are necessary to achieve electrical conductivity. The printed electrically conductive trace relies on good particle to particle physical contact with very low contact resistance in the defined percolated printed traces.

## Claims

1. An electrically conductive electrostatic ink composition comprising:
a liquid carrier; and
particles dispersed in the liquid carrier, wherein the particles comprise:
thermoplastic resin, and
electrically conductive metal particles comprising:
a core comprising a first metal, and
a shell comprising a second metal,
wherein the shell encloses the core at least partially, and
wherein the first metal and the second metal are not the same;
wherein the metal particles comprise from 10 wt% to 40 wt% of the second metal based on the total weight of the metal particles.

2. The electrically conductive electrostatic ink composition according to claim 1, wherein the first metal and the second metal are selected from the group consisting of copper, silver, gold, platinum, titanium, chromium, manganese, iron, nickel rhodium, iridium, and combinations thereof.

3. The electrically conductive electrostatic ink composition according to claim 1, wherein the first metal is copper and the second metal is silver.

4. The electrically conductive electrostatic ink composition according to claim 1, wherein the metal particles constitute at least 75 wt% of the solids of the electrostatic ink composition.

5. The electrically conductive electrostatic ink composition according to claim 1, wherein the particles dispersed in the liquid carrier comprise:
from about 5 wt% to about 25 wt% of the thermoplastic resin based on the total weight of the particles dispersed in the liquid carrier; and
from about 75 wt% to about 95 wt% of the metal particles based on the total weight of the particles dispersed in the liquid carrier.

6. The electrically conductive electrostatic ink composition according to claim 1, wherein the shell substantially completely encloses the core.

7. The electrically conductive electrostatic ink composition according to claim 1, wherein the metal particles have a diameter of from about 1 µm to about 20 µm.

8. The electrically conductive electrostatic ink composition according to claim 1, wherein the thermoplastic resin comprises a polymer selected from a co-polymer of (i) ethylene or propylene and (ii) an ethylenically unsaturated acid of either acrylic acid or methacrylic acid; and ionomers thereof.

9. The electrically conductive electrostatic ink composition according to claim 1, wherein the electrically conductive electrostatic ink composition further comprises a charge director.

10. The electrically conductive electrostatic ink composition according to claim 1, wherein the liquid carrier constitutes at least 30 wt% of the electrically conductive electrostatic ink composition.

11. A method of using the electrically conductive electrostatic ink composition according to claim 1, the method comprising:
adding the electrically conductive electrostatic ink composition according to claim 1 to an ink container.

12. A method of making an electrically conductive electrostatic ink composition, the method comprising:
mixing a liquid carrier and particles dispersed in the liquid carrier, wherein the particles comprise:
thermoplastic resin, and
electrically conductive metal particles comprising:
a core comprising a first metal, and
a shell comprising a second metal,
wherein the shell encloses the core at least partially, and
wherein the first metal and the second metal are not the same;
wherein the metal particles comprise from 10 wt% to 40 wt% of the second metal based on the total weight of the metal particles.

13. The method of making the electrically conductive electrostatic ink composition according to claim 12, wherein the first metal and the second metal are selected from the group consisting of copper, silver, gold, platinum, titanium, chromium, manganese, iron, nickel rhodium, iridium, and combinations thereof.

14. The method of making the electrically conductive electrostatic ink composition according to claim 12, wherein the shell substantially completely encloses the core.

## Patentansprüche

1. Elektrisch leitfähige elektrostatische Tintenzusammensetzung, die Folgendes umfasst:
einen flüssigen Träger; und
Teilchen, die in dem flüssigen Träger dispergiert sind, wobei die Teilchen Folgendes umfassen:
thermoplastisches Harz und
elektrisch leitfähige Metallteilchen, die Folgendes umfassen:
einen Kern, der ein erstes Metall umfasst, und
eine Hülle, die ein zweites Metall umfasst,
wobei die Hülle den Kern wenigstens teilweise einschließt, und
wobei das erste Metall und das zweite Metall nicht gleich sind;
wobei die Metallteilchen von 10 Gew.-% bis 40 Gew.-% des zweiten Metalls, auf der Basis des Gesamtgewichts der Metallteilchen, umfassen.

2. Elektrisch leitfähige elektrostatische Tintenzusammensetzung nach Anspruch 1, wobei das erste Metall und das zweite Metall aus der Gruppe ausgewählt sind, die aus Kupfer, Silber, Gold, Platin, Titan, Chrom, Mangan, Eisen, Nickel-Rhodium, Iridium und Kombinationen davon besteht.

3. Elektrisch leitfähige elektrostatische Tintenzusammensetzung nach Anspruch 1, wobei das erste Metall Kupfer und das zweite Metall Silber ist.

4. Elektrisch leitfähige elektrostatische Tintenzusammensetzung nach Anspruch 1, wobei die Metallteilchen wenigstens 75 Gew.-% der Feststoffe der elektrostatischen Tintenzusammensetzung ausmachen.

5. Elektrisch leitfähige elektrostatische Tintenzusammensetzung nach Anspruch 1, wobei die Teilchen, die in dem flüssigen Träger dispergiert sind, Folgendes umfassen:
von etwa 5 Gew.-% bis etwa 25 Gew.-% des thermoplastischen Harzes, auf der Basis des Gesamtgewichts der Teilchen, die in dem flüssigen Träger dispergiert sind; und
von etwa 75 Gew.-% bis etwa 95 Gew.-% der Metallteilchen, auf der Basis des Gesamtgewichts der Teilchen, die in dem flüssigen Träger dispergiert sind.

6. Elektrisch leitfähige elektrostatische Tintenzusammensetzung nach Anspruch 1, wobei die Hülle den Kern im Wesentlichen vollständig einschließt.

7. Elektrisch leitfähige elektrostatische Tintenzusammensetzung nach Anspruch 1, wobei die Metallteilchen einen Durchmesser von etwa 1 µm bis etwa 20 µm aufweisen.

8. Elektrische leitfähige elektrostatische Tintenzusammensetzung nach Anspruch 1, wobei das thermoplastische Harz ein Polymer umfasst, das aus einem Copolymer von (i) Ethylen oder Propylen und (ii) einer ethylenisch ungesättigten Säure von entweder Acrylsäure oder Methacrylsäure; und lonomeren davon ausgewählt ist; und

9. Elektrisch leitfähige elektrostatische Tintenzusammensetzung nach Anspruch 1, wobei die elektrisch leitfähige elektrostatische Tintenzusammensetzung ferner einen Ladungsleiter umfasst.

10. Elektrisch leitfähige elektrostatische Tintenzusammensetzung nach Anspruch 1, wobei der flüssige Träger wenigstens 30 Gew.-% der elektrisch leitfähigen elektrostatischen Tintenzusammensetzung ausmacht.

11. Verfahren zum Verwenden der elektrisch leitfähigen elektrostatischen Tintenzusammensetzung nach Anspruch 1, wobei das Verfahren Folgendes umfasst:
Hinzufügen der elektrisch leitfähigen elektrostatischen Tintenzusammensetzung nach Anspruch 1 zu einem Tintenbehälter.

12. Verfahren zum Herstellen einer elektrisch leitfähigen elektrostatischen Tintenzusammensetzung, wobei das Verfahren Folgendes umfasst:
Mischen eines flüssigen Trägers und von Teilchen, die in dem flüssigen Träger dispergiert sind, wobei die Teilchen Folgendes umfassen:
thermoplastisches Harz und
elektrisch leitfähige Metallteilchen, die Folgendes umfassen:
einen Kern, der ein erstes Metall umfasst, und
eine Hülle, die ein zweites Metall umfasst,
wobei die Hülle den Kern wenigstens teilweise einschließt, und
wobei das erste Metall und das zweite Metall nicht gleich sind;
wobei die Metallteilchen von 10 Gew.-% bis 40 Gew.% des zweiten Metalls, auf der Basis des Gesamtgewichts der Metallteilchen, umfassen.

13. Verfahren zum Herstellen der elektrisch leitfähigen elektrostatischen Tintenzusammensetzung nach Anspruch 12, wobei das erste Metall und das zweite Metall aus der Gruppe ausgewählt sind, die aus Kupfer, Silber, Gold, Platin, Titan, Chrom, Mangan, Eisen, Nickel-Rhodium, Iridium und Kombinationen davon besteht.

14. Verfahren zum Herstellen der elektrisch leitfähigen elektrostatischen Tintenzusammensetzung nach Anspruch 12, wobei die Hülle den Kern im Wesentlichen vollständig einschließt.

## Revendications

1. Composition d'encre électrostatique électriquement conductrice comprenant :
un véhicule liquide ; et
des particules dispersées dans le véhicule liquide, les particules comprenant :
de la résine thermoplastique, et
des particules métalliques électriquement conductrices comprenant :
un noyau comprenant un premier métal, et
une coque comprenant un second métal,
la coque renfermant au moins partiellement le noyau, et
le premier métal et le second métal n'étant pas les mêmes ;
dans laquelle les particules métalliques comprennent de 10 % en poids à 40 % en poids du second métal sur la base du poids total des particules métalliques.

2. Composition d'encre électrostatique électriquement conductrice selon la revendication 1, dans laquelle le premier métal et le second métal sont choisis dans le groupe constitué par le cuivre, l'argent, l'or, le platine, le titane, le chrome, le manganèse, le fer, le nickel-rhodium, l'iridium et leurs combinaisons.

3. Composition d'encre électrostatique électriquement conductrice selon la revendication 1, dans laquelle le premier métal est le cuivre et le second métal est l'argent.

4. Composition d'encre électrostatique électriquement conductrice selon la revendication 1, dans laquelle les particules métalliques constituent au moins 75 % en poids des solides de la composition d'encre électrostatique.

5. Composition d'encre électrostatique électriquement conductrice selon la revendication 1, dans laquelle les particules dispersées dans le véhicule liquide comprennent :
d'environ 5 % en poids à environ 25 % en poids de la résine thermoplastique sur la base du poids total des particules dispersées dans le véhicule liquide ; et
d'environ 75 % en poids à environ 95 % en poids des particules métalliques sur la base du poids total des particules dispersées dans le véhicule liquide.

6. Composition d'encre électrostatique électriquement conductrice selon la revendication 1, dans laquelle la coque renferme sensiblement complètement le noyau.

7. Composition d'encre électrostatique électriquement conductrice selon la revendication 1, dans laquelle les particules métalliques ont un diamètre d'environ 1 µm à environ 20 µm.

8. Composition d'encre électrostatique selon la revendication 1, dans laquelle la résine thermoplastique comprend un polymère choisi parmi un copolymère (i) d'éthylène ou de propylène et (ii) d'un acide éthylénique insaturé d'acide acrylique ou d'acide méthacrylique.

9. Composition d'encre électrostatique électriquement conductrice selon la revendication 1, dans laquelle la composition d'encre électrostatique électriquement conductrice comprend en outre un directeur de charge.

10. Composition d'encre électrostatique électriquement conductrice selon la revendication 1, dans laquelle le véhicule liquide constitue au moins 30 % en poids de la composition d'encre électrostatique électriquement conductrice.

11. Procédé d'utilisation de la composition d'encre électrostatique selon la revendication 1, le procédé comprenant :
l'ajout de la composition d'encre électrostatique électriquement conductrice selon la revendication 1 à un récipient d'encre.

12. Procédé de fabrication d'une composition d'encre électrostatique, le procédé comprenant :
le mélange d'un véhicule liquide et de particules dispersées dans le véhicule liquide, les particules comprenant :
de la résine thermoplastique, et
des particules métalliques électriquement conductrices comprenant :
un noyau comprenant un premier métal, et
une coque comprenant un second métal,
la coque renfermant au moins partiellement le noyau, et
le premier métal et le second métal n'étant pas les mêmes ;
les particules métalliques comprenant de 10 % en poids à 40 % en poids du second métal sur la base du poids total des particules métalliques.

13. Procédé de fabrication de la composition d'encre électrostatique électriquement conductrice selon la revendication 12, dans lequel le premier métal et le second métal sont choisis dans le groupe constitué par le cuivre, l'argent, l'or, le platine, le titane, le chrome, le manganèse, le fer, le nickel-rhodium, l'iridium, et leurs combinaisons.

14. Procédé de fabrication de la composition d'encre électrostatique électriquement conductrice selon la revendication 12, dans lequel la coque renferme sensiblement complètement le noyau.
